# EUROPEAN PATENT APPLICATION

(11) **EP 4 835 693 A1**
(43) Date of publication of application: **04.11.2026**
(21) Application number: 26162298.9
(22) Date of filing: 04.03.2026
(51) Int. Cl.: G06F 17/10

(54) **METHOD AND SYSTEM FOR GRAPH GENERATION FOR A MATHEMATICAL FUNCTION**

(30) Priority: 07.03.2025 IN 202521020809
(71) Applicant: Tata Consultancy Services Limited, Maharashtra (IN)
(72) Inventor: DASGUPTA, Indrapratim, 700156 Kolkata, West Bengal (IN); AGRAWAL, Anshul Kumar, 700156 Kolkata, West Bengal (IN); DHAR, Subhasish, 700156 Kolkata, West Bengal (IN); CHAKRABORTY, Kaushik, 700156 Kolkata, West Bengal (IN); CHAKRABORTY, Sourav, 700156 Kolkata, West Bengal (IN); BOSE, Subhasish, 700156 Kolkata, West Bengal (IN)
(74) Representative: Goddar, Heinz J.

(57) **Abstract**

Existing tools for generating graphs for mathematical functions are able to generate only 2-D graphs. They use client-side execution on the browser, which limits scalability and extensibility. Embodiments disclosed herein provide a method and system for graph generation for mathematical functions. The system obtains a) a string representation of a mathematical function to be plotted, and b) one or more visual inputs governing creation of a plot representing the string representation of the mathematical function, as input data. Then the system processes the input data using various functions to extract data that can be used for the graph generation, and then based on the requirements specified by the input data, generates a graph.

## Description

### CROSS-REFERENCE TO RELATED APPLICATIONS AND PRIORITY

The present application claims priority to Indian application no. 202521020809, filed on March 7, 2025.

### TECHNICAL FIELD

The disclosure herein generally relates to graph generation, and, more particularly, to a method and system for graph generation for a mathematical function.

### BACKGROUND

As textbooks and scholarly publications get fully digitized, the need for creating high-end mathematical graphs in physics and mathematics, especially for visualizing continuous-domain functions in 2-D, 3-D or n-D spaces, in these digital textbooks / journals is paramount, especially where it is very important for the student to visualize a particular function / field. Many existing tools that integrate with authoring platforms are focused on 2-D graphs. Also, most of them use client-side execution on the browser. This limits scalability and extensibility. Some of the major existing platforms / tools for graph generation use highly proprietary software, which are not widely used and often have a costly license associated with them.

### SUMMARY

Embodiments of the present disclosure present technological improvements as solutions to one or more of the above-mentioned technical problems recognized by the inventors in conventional systems. For example, in one embodiment, a processor implemented method is provided. The method includes: obtaining, via one or more hardware processors, at least one of a) a string representation of a mathematical function to be plotted, and b) one or more visual inputs governing creation of a plot representing the string representation of the mathematical function, as input data; generating, via the one or more hardware processors, a bounded domain space, comprising: generating an array of evenly spaced points, between an upper bound and a lower bound, along each of a plurality of dimensions of a domain space; and generating the bounded domain space using a plurality of the arrays associated with the plurality of dimensions; generating, via the one or more hardware processors, a mathematical function representation of the mathematical function to be plotted, comprising: creating a plurality of symbolic variables associated with each of the plurality of dimensions; converting the input string representation of the mathematical function to a standard mathematical function representation using the plurality of symbolic variables; and converting the standard mathematical function representation into a lambda function, wherein the lambda function is a processable representation of the mathematical function; applying, via the one or more hardware processors, the lambda function to each of a plurality of discrete points defined in the plurality of arrays in the bounded domain space to obtain a function range; plotting, via the one or more hardware processors, the function range on the bounded domain space, based on the one or more visual inputs to obtain the graph; and configuring, via the one or more hardware processors, one or more labels on along axes of each of the plurality of dimensions, of the graph, and a latex representation of the mathematical function as label of the graph.

In another aspect of the method, the one or more visual inputs comprise size of graph, and color scheme.

In another aspect of the method, the string representation of the mathematical function comprises at least one variable, and wherein number of the plurality of dimensions of the bounded domain space in which the graph is to be plotted is equal to number of variables in the mathematical function.

In another aspect of the method, the Lambda function is represented as: $L = I \left(F\right) = l \left(f\left({x}_{1},{x}_{2},….{x}_{n}\right)\right) ,$ where, *F* is a function represented as a symbolic expression, *x*₁, *x*₂, ... . *xₙ* are real-valued variables, *f* is a real-valued function mapping, and *I* is a final transformation that converts *F* into the Lambda function.

In another aspect of the method, the bounded domain space is represented as: $S = \left\{\left.{P}_{k}\right|k∈N\right\} ,$ where each *Pₖ =* {*P* (*i*1, *i*2, ... . ,)| *i*1 ∈ 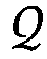 *, i*2 ∈ 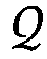 *, and i*3 ∈ 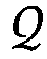 ..}, 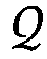 is domain of rational numbers, and each *P* (*i*1, *i*2, ... . ,) represents a vector in an n-dimensional space.

In another aspect, a system is provided. The system includes one or more hardware processors, a communication interface, and a memory storing a plurality of instructions. The plurality of instructions when executed, cause the one or more hardware processors to: obtain at least one of a) a string representation of a mathematical function to be plotted, and b) one or more visual inputs governing creation of a plot representing the string representation of the mathematical function, as input data; generate a bounded domain space, by: generating an array of evenly spaced points, between an upper bound and a lower bound, along each of a plurality of dimensions of a domain space; and generating the bounded domain space using a plurality of the arrays associated with the plurality of dimensions; generate a mathematical function representation of the mathematical function to be plotted, by: creating a plurality of symbolic variables associated with each of the plurality of dimensions; converting the input string representation of the mathematical function to a standard mathematical function representation using the plurality of symbolic variables; and converting the standard mathematical function representation into a lambda function, wherein the lambda function is a processable representation of the mathematical function; apply the lambda function to each of a plurality of discrete points defined in the plurality of arrays in the bounded domain space to obtain a function range; plot the function range on the bounded domain space, based on the one or more visual inputs to obtain the graph; and configure one or more labels on along axes of each of the plurality of dimensions, of the graph, and a latex representation of the mathematical function as label of the graph.

In an aspect of the system, the one or more visual inputs comprise size of graph, and color scheme.

In another aspect of the system, the string representation of the mathematical function comprises at least one variable, and wherein number of the plurality of dimensions of the bounded domain space in which the graph is to be plotted is equal to number of variables in the mathematical function.

In another aspect of the system, the Lambda function is represented as: $L = I \left(F\right) = l \left(f\left({x}_{1},{x}_{2},….{x}_{n}\right)\right) ,$ where, *F* is a function represented as a symbolic expression, *x*₁, *x*₂, ... *. xₙ* are real-valued variables, *f* is a real-valued function mapping, and *I* is a final transformation that converts *F* into the Lambda function.

In another aspect of the system, the bounded domain space is represented as: $S = \left\{\left.{P}_{k}\right|k∈N\right\} ,$ where each *Pₖ*
*=* {*P* (*i*1, *i2,* ... . , )| *i*1 ∈ 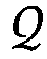 *, i*2 ∈ 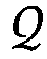 *, and i*3
∈ 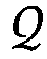 .. }, 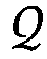 is domain of rational numbers, and each *P* (*i*1, *i*2*,* ... . , ) represents a vector in an n - dimensional space.

In yet another aspect, there are provided one or more non-transitory machine-readable information storage media comprising one or more instructions which when executed by one or more hardware processors cause obtaining at least one of a) a string representation of a mathematical function to be plotted, and b) one or more visual inputs governing creation of a plot representing the string representation of the mathematical function, as input data; generating, a bounded domain space, comprising: generating an array of evenly spaced points, between an upper bound and a lower bound, along each of a plurality of dimensions of a domain space; and generating the bounded domain space using a plurality of the arrays associated with the plurality of dimensions; generating a mathematical function representation of the mathematical function to be plotted, comprising: creating a plurality of symbolic variables associated with each of the plurality of dimensions; converting the input string representation of the mathematical function to a standard mathematical function representation using the plurality of symbolic variables; and converting the standard mathematical function representation into a lambda function, wherein the lambda function is a processable representation of the mathematical function; applying the lambda function to each of a plurality of discrete points defined in the plurality of arrays in the bounded domain space to obtain a function range; plotting the function range on the bounded domain space, based on the one or more visual inputs to obtain the graph; and configuring one or more labels on along axes of each of the plurality of dimensions, of the graph, and a latex representation of the mathematical function as label of the graph.

In another aspect of the one or more non-transitory computer readable medium, , the one or more visual inputs comprise size of graph, and color scheme.

In another aspect of the one or more non-transitory computer readable medium, the string representation of the mathematical function comprises at least one variable, and wherein number of the plurality of dimensions of the bounded domain space in which the graph is to be plotted is equal to number of variables in the mathematical function.

In another aspect of the one or more non-transitory computer readable medium, the Lambda function is represented as: $L = I \left(F\right) = l \left(f\left({x}_{1},{x}_{2},….{x}_{n}\right)\right) ,$ where, *F* is a function represented as a symbolic expression, *x*₁, *x*₂, ... *. xₙ* are real-valued variables, *f* is a real-valued function mapping, and *I* is a final transformation that converts *F* into the Lambda function.

In another aspect of the non-transitory computer readable medium, the bounded domain space is represented as: $S = \left\{\left.{P}_{k}\right|k∈N\right\} ,$ where each *Pₖ =* {*P* (*i*1, *i*2, ... . ,)| *i*1 ∈ 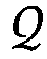 *, i*2 ∈ 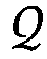 *, and i*3 ∈ 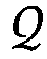 *.*.}*,* 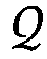 is domain of rational numbers, and each *P* (*i*1, *i*2, ... . , ) represents a vector in an n-dimensional space.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1A illustrates an exemplary system for graph generation for mathematical functions, according to some embodiments of the present disclosure.
FIG. 1B illustrates an example implementation of the system of FIG. 1A, according to some embodiments of the present disclosure.
FIG. 2 is a flow diagram depicting steps involved in the process of graph generation for mathematical functions, using the system of FIG. 1A, according to some embodiments of the present disclosure.
FIG. 3 is a flow diagram depicting steps involved in the process of generating a bounded domain space, by the system of FIG. 1A, according to some embodiments of the present disclosure.
FIG. 4 is a flow diagram depicting steps involved in the process of generating a mathematical function representation of the mathematical function to be plotted, by the system of FIG. 1A, according to some embodiments of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

For digitization and other such purposes, creating high-end mathematical graphs in physics and mathematics, especially for visualizing continuous-domain functions in 2-D, 3-D or n-D spaces, is important. Existing approaches involve use of client-side execution on the browser, which limits scalability and extensibility. Some of the major existing platforms / tools for graph generation use highly proprietary software, which are not widely used and often have a costly license associated with them.

To address these challenges, the embodiments disclosed herein provide a method and system for graph generation for mathematical functions. The approach involves: obtaining, via one or more hardware processors, at least one of a) a string representation of a mathematical function to be plotted, and b) one or more visual inputs governing creation of a plot representing the string representation of the mathematical function, as input data; generating, via the one or more hardware processors, a bounded domain space, comprising: generating an array of evenly spaced points, between an upper bound and a lower bound, along each of a plurality of dimensions of a domain space; and generating the bounded domain space using a plurality of the arrays associated with the plurality of dimensions; generating, via the one or more hardware processors, a mathematical function representation of the mathematical function to be plotted, comprising: creating a plurality of symbolic variables associated with each of the plurality of dimensions; converting the input string representation of the mathematical function to a standard mathematical function representation using the plurality of symbolic variables; and converting the standard mathematical function representation into a lambda function, wherein the lambda function is a processable representation of the mathematical function; applying, via the one or more hardware processors, the lambda function to each of a plurality of discrete points defined in the plurality of arrays in the bounded domain space to obtain a function range; plotting, via the one or more hardware processors, the function range on the bounded domain space, based on the one or more visual inputs to obtain the graph; and configuring, via the one or more hardware processors, one or more labels on along axes of each of the plurality of dimensions, of the graph, and a latex representation of the mathematical function as label of the graph.

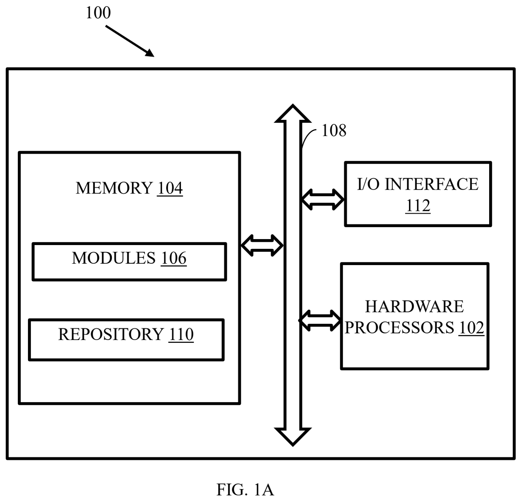

Referring now to the drawings, and more particularly to FIG. 1A through FIG. 4, where similar reference characters denote corresponding features consistently throughout the figures, there are shown preferred embodiments and these embodiments are described in the context of the following exemplary system and/or method.

FIG. 1A illustrates an exemplary system for graph generation for mathematical functions, according to some embodiments of the present disclosure.

The system 100 includes or is otherwise in communication with hardware processors 102, at least one memory such as a memory 104, an I/O interface 112. The hardware processors 102, memory 104, and the Input /Output (I/O) interface 112 may be coupled by a system bus such as a system bus 108 or a similar mechanism. In an embodiment, the hardware processors 102 can be one or more hardware processors.

The I/O interface 112 may include a variety of software and hardware interfaces, for example, a web interface, a graphical user interface, and the like. The I/O interface 112 may include a variety of software and hardware interfaces, for example, interfaces for peripheral device(s), such as a keyboard, a mouse, an external memory, a printer and the like. Further, the I/O interface 112 may enable the system 100 to communicate with other devices, such as web servers, and external databases.

The I/O interface 112 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface 112 may include one or more ports for connecting several computing systems with one another or to another server computer. The I/O interface 112 may include one or more ports for connecting several devices to one another or to another server.

The one or more hardware processors 102 may be implemented as one or more microprocessors, microcomputers, microcontrollers, digital signal processors, central processing units, node machines, logic circuitries, and/or any devices that manipulate signals based on operational instructions. Among other capabilities, the one or more hardware processors 102 is configured to fetch and execute computer-readable instructions stored in the memory 104.

The memory 104 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. In an embodiment, the memory 104 includes a plurality of modules 106.

The plurality of modules 106 include programs or coded instructions that supplement applications or functions performed by the system 100 for executing different steps involved in the process of graph generation for mathematical functions, being performed by the system of FIG. 1A. The plurality of modules 106, amongst other things, can include routines, programs, objects, components, and data structures, which performs particular tasks or implement particular abstract data types. The plurality of modules 106 may also be used as, signal processor(s), node machine(s), logic circuitries, and/or any other device or component that manipulates signals based on operational instructions. Further, the plurality of modules 106 can be used by hardware, by computer-readable instructions executed by the one or more hardware processors 102, or by a combination thereof. The plurality of modules 106 can include various sub-modules (not shown). The plurality of modules 106 may include computer-readable instructions that supplement applications or functions performed by the system 100 for the graph generation for mathematical functions.

The data repository (or repository) 110 may include a plurality of abstracted piece of code for refinement and data that is processed, received, or generated as a result of the execution of the plurality of modules in the module(s) 106.

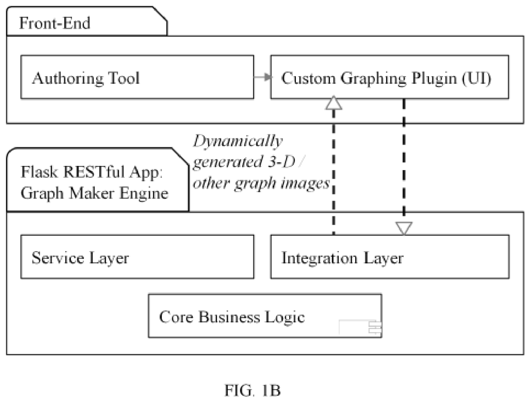

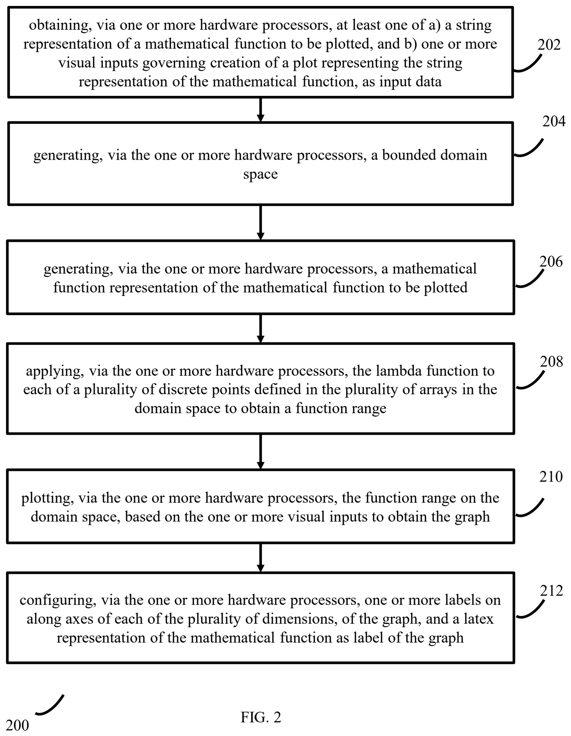

Although the data repository 110 is shown internal to the system 100, it will be noted that, in alternate embodiments, the data repository 110 can also be implemented external to the system 100, where the data repository 110 may be stored within a database (repository 110) communicatively coupled to the system 100. The data contained within such external database may be periodically updated. For example, new data may be added into the database (not shown in FIG. 1A) and/or existing data may be modified and/or non-useful data may be deleted from the database. In one example, the data may be stored in an external system, such as a Lightweight Directory Access Protocol (LDAP) directory and a Relational Database Management System (RDBMS). Working of the components of the system 100 are now explained with reference to the example implementation in FIG. 1B, and the steps in the flow diagrams in FIG. 2, FIG. 3, and FIG. 4. The example implementation of the system of FIG. 1A, as in FIG. 1B, has a front-end and a Flask RESTful API app: Graph maker engine. The front-end facilitates integration of the system 100 to one or more external systems. All the data processing covered in method 200 in FIG. 2 are being executed by the Graph maker engine.

FIG. 2 is a flow diagram depicting steps involved in the process of graph generation for mathematical functions, using the system of FIG. 1A, according to some embodiments of the present disclosure.

In an embodiment, the system 100 comprises one or more data storage devices or the memory 104 operatively coupled to the processor(s) 102 and is configured to store instructions for execution of steps of a method 200 in FIG. 2, by the processor(s) or one or more hardware processors 102. The steps of the method 200 of the present disclosure will now be explained with reference to the components or blocks of the system 100 as depicted in FIG. 1A, and the steps of flow diagram as depicted in FIGS. 2. Although process steps, method steps, techniques or the like may be described in a sequential order, such processes, methods, and techniques may be configured to work in alternate orders. In other words, any sequence or order of steps that may be described does not necessarily indicate a requirement that the steps to be performed in that order. The steps of processes described herein may be performed in any order practical. Further, some steps may be performed simultaneously.

At step 202 of the method 200, the system 100 obtains, via the one or more hardware processors 102, at least one of a) a string representation of a mathematical function to be plotted, and b) one or more visual inputs governing creation of a plot representing the string representation of the mathematical function, as input data. The input data maybe fed to the system 100 via one or more suitable interfaces, by any authorized user. In another embodiment, the input data maybe automatically fetched by the system 100 from one or more associated systems. The mathematical function may be a real-valued function of a single real variable (i.e., whose domain is real and the range is real) that can be plotted in 2-Dimensional (2D) space, or a real function of two real variables that can be plotted in 3-Dimensional (3D) space. 4-D, 5-D, n-D graphs can be considered as graphs of real variables. Graphs of complex variables may either be graphs of the real part of the range, or the imaginary part of the range, or the modulus of the range, or graphs of the entire range. In yet another embodiment, one or more 'template functions' maybe selected and used (for example, paraboloid, polynomials and so on), with respective coefficients, for generating the string representation. Other parameters that maybe fed as input to the system 100 are, but not limited to, size of graph to be generated, and color scheme of the graph. The string representation of the mathematical function comprises at least one variable, and wherein number of the plurality of dimensions of a bounded domain space in which the graph is to be plotted is equal to number of variables in the mathematical function.

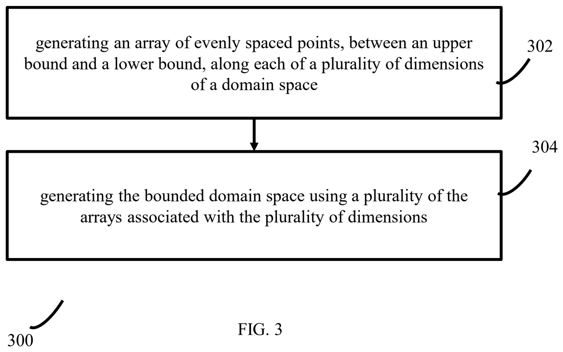

Further, at step 204 of the method 200, the system 100 generates, via the one or more hardware processors 102, a bounded domain space. The bounded domain space comprises discrete space of points generated in x, y planes, between set limits, for example, x values between -10 to +10, and y-values between -10 to +10, etc., and so on. The bounded domain space is a domain of the function, discretized so that it can be process-able to generate a graph of the function range, in a discrete manner. Steps involved in the process of generating the bounded domain space are depicted in method 300 in FIG. 3, and are explained herein. At step 302 of the method 300, the system 100 generates an array of evenly spaced points, between an upper bound and a lower bound, along each of a plurality of dimensions of a domain space. Values of the upper bound and the lower bound maybe defined and configured with the system 100. For example, for a 2-D domain space, a sample creation of the array along the y dimension could be defined by *y_values = np.linespace*(-5, 5, 100), which defines an array of a 100 points, starting with -5, -4.9, -4.8, and ending with 4.7, 4.8, 4.9, and 5. Further, at step 304 of the method 300, the system 100 generates the bounded domain space using a plurality of the arrays associated with the plurality of dimensions. In an embodiment, the bounded domain space generated is a discrete domain space which does not have bounds along each dimension, and may not also have same discrete unit along each dimension. For example, the x-dimension may be "chunked" in units of 0.2 instead of 0.1, and have a total number of 300 chunks, instead of 100 chunks, in contrast to the example given above for the y-dimension. For a two-dimensional domain, such a grid space or vector space can be created using a function call *X, Y* = *np.meshgrid*(*x_values, y_values*). The bounded domain space is represented as: $S = \left\{\left.{P}_{k}\right|k∈N\right\}$ (1) where each *Pₖ* = {*P* (*i*1, *i*2, ... . , )| *i*1 ∈ 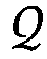 *, i*2 ∈ 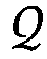 *, and i*3 ∈ 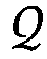 .. }, 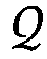 is domain of rational numbers, and each *P* (*i*1, *i*2, ... . , ) represents a vector in an n-dimensional space.

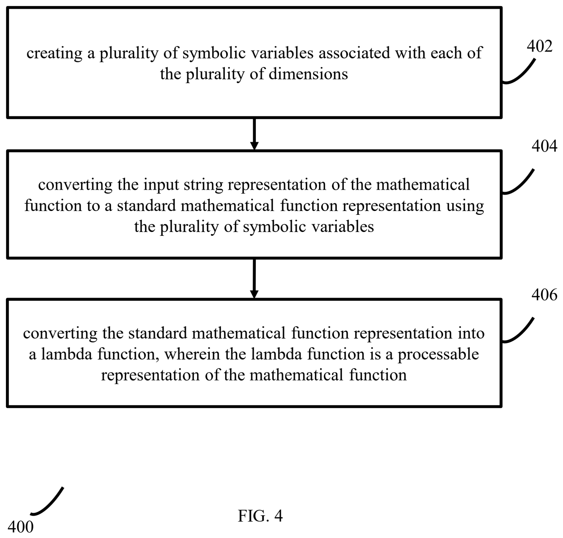

Referring back to the method 200, at step 206, the system 100 generates, via the one or more hardware processors 102, a mathematical function representation of the mathematical function to be plotted. Various steps involved in the process of generating the mathematical function representation are depicted in method 400 in FIG. 4, and are explained hereafter. At step 402 of the method 400, the system 100 creates a plurality of symbolic variables associated with each of the plurality of dimensions, for example, x, y. The input equation is in the form of a string, for example, as *sin*(*sqrt*(*x*² + *y*²)). At step 404 of the method 400, the system 100 converts the input string representation of the mathematical function to a standard mathematical function representation using the plurality of symbolic variables. The conversion is done such that the mathematical function representations can be mapped to a data type or data structure to an associated symbolic representation. Further, at step 406 of the method 400, the system 100 converts the standard mathematical function representation into a lambda function. The lambda function is a processable representation of the mathematical function, and is represented as: $L = I \left(F\right) = l \left(f\left({x}_{1},{x}_{2},….{x}_{n}\right)\right) ,$ (2) where, *F* is a function represented as a symbolic expression, *x*₁, *x*₂, ... *. xₙ* are real-valued variables, *f* is a real-valued function mapping, and *I* is a final transformation that converts *F* into the Lambda function.

Referring back to the method 200, at step 208, the system 100 applies, via the one or more hardware processors 102, the lambda function to each of a plurality of discrete points defined in the plurality of arrays in the bounded domain space to obtain a function range. At this step, any coordinate point or input vector in the bounded domain space, i.e., the discrete domain space, can be passed as input to this lambda function.

Further, at step 210 of the method 400, the system 100 plots, via the one or more hardware processors 102, the function range on the bounded domain space, based on the one or more visual inputs to obtain the graph. With the function range defined as a set of range points or vectors, the range is plotted on the domain, with the additional parameters of the color scheme, the size of the graph, and so on. At this step, a "figure" is created with a specified width or height, to add a 3D projection to the figure in case a 3D graph is required, and to finally plot the surface, using the bounded domain space, the calculated range, the figure dimensions and the color map specified are used.

Further, at step 212 of the method 200, the system 100 configures, via the one or more hardware processors 102, one or more labels along axes of each of the plurality of dimensions, of the graph. Additionally, the input function is converted to a latex representation of the mathematical function as label of the graph, which is represented as: ${E}_{L} = e \left(F\right) = e \left(f\left({x}_{1},{x}_{2},…,{x}_{n}\right)\right)$ (3)

This is done so that the input function can be visualized as a label alongside the generated graph. Based on this, an image of the graph *M,* on a target space, with the dimension labels and the latex function representation, is generated. The generated image maybe saved in an associated storage space, and may also be given as output of the system, as a response to the user.

In an embodiment, the system 100 may be implemented as a server-side, horizontally scalable, and API based system, and may use python libraries. In an embodiment, the system 100 may be implemented as a pluggable unit, that may be plugged in to any compatible authoring tool with minimal changes, to support graph generation for one or more mathematical functions.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein address unresolved problem of graph generation for mathematical functions. The embodiment, thus provides a mechanism for graph generation for mathematical functions. Moreover, the embodiments herein further facilitates digitization of contents having mathematical data.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method, comprising:
obtaining (202), via one or more hardware processors, at least one of (a) a string representation of a mathematical function to be plotted, and b) one or more visual inputs governing creation of a plot representing the string representation of the mathematical function, as input data;
generating (204), via the one or more hardware processors, a bounded domain space, comprising:
generating (302) an array of evenly spaced points, between an upper bound and a lower bound, along each of a plurality of dimensions of a domain space; and
generating (304) the bounded domain space using a plurality of the arrays associated with the plurality of dimensions;
generating (206), via the one or more hardware processors, a mathematical function representation of the mathematical function to be plotted, comprising:
creating (402) a plurality of symbolic variables associated with each of the plurality of dimensions;
converting (404) the input string representation of the mathematical function to a standard mathematical function representation using the plurality of symbolic variables; and
converting (406) the standard mathematical function representation into a lambda function, wherein the lambda function is a processable representation of the mathematical function;
applying (208), via the one or more hardware processors, the lambda function to each of a plurality of discrete points defined in the plurality of arrays in the bounded domain space to obtain a function range;
plotting (210), via the one or more hardware processors, the function range on the bounded domain space, based on the one or more visual inputs to obtain the graph; and
configuring (212), via the one or more hardware processors, one or more labels on along axes of each of the plurality of dimensions, of the graph,
and a latex representation of the mathematical function as label of the graph.

2. The processor implemented method as claimed in claim 1, wherein the one or more visual inputs comprise size of graph, and color scheme.

3. The processor implemented method as claimed in claim 1, wherein the string representation of the mathematical function comprises at least one variable, and wherein number of the plurality of dimensions of the bounded domain space in which the graph is to be plotted is equal to number of variables in the mathematical function.

4. The processor implemented method as claimed in claim 1, wherein the Lambda function is represented as: $L = I \left(F\right) = l \left(f\left({x}_{1},{x}_{2},….{x}_{n}\right)\right) ,$ where, *F* is a function represented as a symbolic expression, *x*₁, *x*₂, ... *. xₙ* are real-valued variables, *f* is a real-valued function mapping, and *I* is a final transformation that converts *F* into the Lambda function.

5. The processor implemented method as claimed in claim 1, wherein the bounded domain space is represented as: $S = \left\{\left.{P}_{k}\right|k∈N\right\} ,$ where each *Pₖ =* {*P* (*i*1, *i*2, ... . ,)| *i*1 ∈ 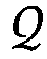 *, i*2 ∈ 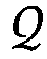 *, and i*3 ∈ 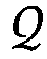 ..}, 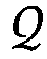 is domain of rational numbers, and each *P* (*i*1, *i*2, ... *.* ,) represents a vector in an n-dimensional space.

6. A system (100), comprising:
one or more hardware processors (102);
a communication interface (112); and
a memory (104) storing a plurality of instructions which when executed, cause the one or more hardware processors to:
obtain at least one of (a) a string representation of a mathematical function to be plotted, and (b) one or more visual inputs governing creation of a plot representing the string representation of the mathematical function, as input data;
generate a bounded domain space, by:
generating an array of evenly spaced points, between an upper bound and a lower bound, along each of a plurality of dimensions of a domain space; and
generating the bounded domain space using a plurality of the arrays associated with the plurality of dimensions;
generate a mathematical function representation of the mathematical function to be plotted, by:
creating a plurality of symbolic variables associated with each of the plurality of dimensions;
converting the input string representation of the mathematical function to a standard mathematical function representation using the plurality of symbolic variables; and
converting the standard mathematical function representation into a lambda function, wherein the lambda function is a processable representation of the mathematical function;
apply the lambda function to each of a plurality of discrete points defined in the plurality of arrays in the bounded domain space to obtain a function range;
plot the function range on the bounded domain space, based on the one or more visual inputs to obtain the graph; and
configure one or more labels on along axes of each of the plurality of dimensions, of the graph, and a latex representation of the mathematical function as label of the graph.

7. The system as claimed in claim 6, wherein the one or more visual inputs comprise size of graph, and color scheme.

8. The system as claimed in claim 6, wherein the string representation of the mathematical function comprises at least one variable, and wherein number of the plurality of dimensions of the bounded domain space in which the graph is to be plotted is equal to number of variables in the mathematical function.

9. The system as claimed in claim 6, wherein the Lambda function is represented as: $L = I \left(F\right) = l \left(f\left({x}_{1},{x}_{2},….{x}_{n}\right)\right) ,$ where, *F* is a function represented as a symbolic expression, *x*₁, *x*₂, ... *. xₙ* are real-valued variables, *f* is a real-valued function mapping, and *I* is a final transformation that converts *F* into the Lambda function.

10. The system as claimed in claim 6, wherein the bounded domain space is represented as: $S = \left\{\left.{P}_{k}\right|k∈N\right\} ,$ where each *Pₖ*
*= {P* (*i*1, *i2,* ... . , )| *i*1 ∈ 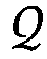 *, i*2 ∈ 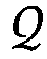 *, and i*3
∈ 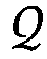 ..}, 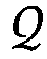 is domain of rational numbers, and each *P* (*i*1, *i*2*,* ... . , ) represents a vector in an n - dimensional space.

11. One or more non-transitory machine-readable information storage mediums comprising one or more instructions which when executed by one or more hardware processors cause:
obtaining at least one of (a) a string representation of a mathematical function to be plotted, and (b) one or more visual inputs governing creation of a plot representing the string representation of the mathematical function, as input data;
generating a bounded domain space, comprising:
generating an array of evenly spaced points, between an upper bound and a lower bound, along each of a plurality of dimensions of a domain space; and
generating the bounded domain space using a plurality of the arrays associated with the plurality of dimensions;
generating a mathematical function representation of the mathematical function to be plotted, comprising:
creating a plurality of symbolic variables associated with each of the plurality of dimensions;
converting the input string representation of the mathematical function to a standard mathematical function representation using the plurality of symbolic variables; and
converting the standard mathematical function representation into a lambda function, wherein the lambda function is a processable representation of the mathematical function;
applying the lambda function to each of a plurality of discrete points defined in the plurality of arrays in the bounded domain space to obtain a function range;
plotting the function range on the bounded domain space, based on the one or more visual inputs to obtain the graph; and
configuring one or more labels on along axes of each of the plurality of dimensions, of the graph, and a latex representation of the mathematical function as label of the graph.

12. The one or more non-transitory machine-readable information storage mediums as claimed in claim 11, wherein the one or more visual inputs comprise size of graph, and color scheme.

13. The one or more non-transitory machine-readable information storage mediums as claimed in claim 11, wherein the string representation of the mathematical function comprises at least one variable, and wherein number of the plurality of dimensions of the bounded domain space in which the graph is to be plotted is equal to number of variables in the mathematical function.

14. The one or more non-transitory machine-readable information storage mediums as claimed in claim 11, wherein the Lambda function is represented as: $L = I \left(F\right) = l \left(f\left({x}_{1},{x}_{2},….{x}_{n}\right)\right) ,$ where, *F* is a function represented as a symbolic expression, *x*₁, *x*₂, ... *. xₙ* are real-valued variables, *f* is a real-valued function mapping, and *I* is a final transformation that converts *F* into the Lambda function.

15. The one or more non-transitory machine-readable information storage mediums as claimed in claim 11, wherein the bounded domain space is represented as: *S =* {*Pₖ* | *k* ∈ *N*}, where each *Pₖ =* {*P* (*i*1, *i*2, ... . *,* )| *i*1 ∈ 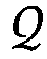 *, i*2 ∈ 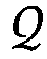 *, and i*3 ∈ 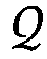 ..}, 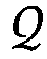 is domain of rational numbers, and each *P* (*i*1, *i*2, ... . , ) represents a vector in an n-dimensional space.
